# EUROPÄISCHE PATENTSCHRIFT

(11) **EP 3 714 474 B1**
(45) Veröffentlichungstag und Bekanntmachung des Hinweises auf die Patenterteilung: **07.08.2024**
(21) Anmeldenummer: 18807296.1
(22) Anmeldetag: 20.11.2018
(51) Int. Cl.: H01H 33/59, H01H 9/54

(54) **SCHALTVORRICHTUNG ZUM FÜHREN UND TRENNEN VON ELEKTRISCHEN STRÖMEN UND SCHALTGERÄT MIT EINER DERARTIGEN SCHALTVORRICHTUNG**
SWITCHING DEVICE FOR CONDUCTING AND DISCONNECTING ELECTRIC CURRENTS AND SWITCHING APPARATUS WITH SUCH A SWITCHING DEVICE
DISPOSITIF DE COMMUTATION POUR CONDUIRE ET DECONNECTER DES COURANTS ELECTRIQUES ET APPAREIL DE COMMUTATION AVEC UN TEL DISPOSITIF DE COMMUTATION

(30) Priorität: 24.11.2017 DE 102017127886
(43) Veröffentlichungstag der Anmeldung: 30.09.2020
(73) Patentinhaber: Eaton Intelligent Power Limited, Dublin 4 (IE)
(72) Erfinder: MEISSNER, Johannes, 53129 Bonn (DE); SCHMITZ, Gerd, 53859 Niederkassel (DE); SCHROEDER, Kai, 53859 Niederkassel (DE); WOHLANG, Michael, 53332 Bornheim (DE); KREFT, Oliver, 53119 Bonn (DE); UEDELHOVEN, Marcel, 53945 Blankenheim (DE)
(74) Vertreter: Epping - Hermann - Fischer
(86) Internationale Anmeldenummer: PCT/EP2018/081941
(87) Internationale Veröffentlichungsnummer: WO 2019/101744

(56) Entgegenhaltungen:
- EP-A1- 0 011 958
- EP-A1- 3 057 117
- EP-A2- 0 179 982
- WO-A1-2017/174326
- US-A- 4 420 784
- US-A1- 2005 212 497

## Beschreibung

Die vorliegende Offenbarung betrifft eine Schaltvorrichtung zum Führen und Trennen von elektrischen Strömen, insbesondere eine Hybridschaltanordnung zum Führen und Trennen hoher DC-Ströme und niederfrequenter AC-Ströme, und ein Schaltgerät mit einer derartigen Schaltvorrichtung.

In der der deutschen Offenlegungsschrift DE 10 2013 114 259 A1 ist eine vorteilhafte Variante einer Hybridschaltanordnung beschrieben, bei der die Strombelastung des Leistungshalbleiters zur Erzielung einer möglichst hohen Lebenserwartung sowie einer möglichst geringen Dimensionierung zeitlich minimiert ist, was vor allem bei Leistungsschützen im Strombereich einiger hundert Ampere wichtig ist. Zur zeitlichen Minimierung des durch den Leistungshalbleiter fließenden Laststroms wird über einen Stromwandler der Kommutierungszeitpunkt erfasst und der Stromfluss durch den Halbleiter nur so lange aufrechterhalten, bis die sich öffnende mechanische Schaltstrecke eine ausreichende elektrische Festigkeit erreicht hat. In dieser kurzen Zeit wird der Laststrom durch den Halbleiter über dessen Ansteuerung künstlich zu Null geführt, so dass nach Öffnen sowohl der Löschkontakt- als auch der hierzu in Reihe geschalteten Trennkontaktanordnung eine sichere galvanische Trennung erzielt wird.

Bei der Auslegung eines Schaltgeräts besteht eine wichtige Aufgabe darin, zur Gewährleistung der Funktionssicherheit sowie zur Erzielung einer hohen elektrischen Lebensdauer ein Verschweißen der Schaltkontakte zu verhindern. Auch bei Verwendung eines geeigneten Kontaktwerkstoffs sowie ausreichender Kontaktgröße besteht v.a. bei Schaltgeräten für Ströme im Bereich einiger hundert Ampere, wofür vergleichsweise hohe Kontaktdruckkräfte erforderlich sind, prinzipiell die Gefahr, dass es bei der Kontaktgabe während des Einschaltvorgangs zu einem kurzen Rückprellen der Kontakte kommt. Bei einem solchen Prellvorgang kommt es zwischen den minimal geöffneten Kontakten kurzzeitig zur Ausbildung eines Lichtbogens. Insbesondere bei hohen Bogenströmen kann es dabei im Bereich der Fußpunkte zu lokalen Aufschmelzungen der Kontaktoberflächen kommen, welche bei der unmittelbar nachfolgenden erneuten Kontaktierung dann zu einer Verschweißung der beiden Kontakte führt. Die Neigung zum Verschweißen steigt hierbei insbesondere bei solchen Kontakten, deren Oberflächen durch zahlreiche lichtbogenbehaftete Schalthandlungen bereits eine stark veränderte Topografie aufweisen. Hier kommt es vorzugsweise im Bereich von Kontaktspitzen zu punktuellen Verschweißungen. Gelingt es beim nachfolgenden Ausschaltvorgang nicht, eine solche Verschweißung mit Hilfe des Schaltantriebs wieder aufzubrechen, ist das Schaltgerät nicht mehr funktionstüchtig. Dies gilt grundsätzlich auch für Hybridschalter. Kommt es beispielsweise beim Einschalten der in der deutschen Offenlegungsschrift DE 10 2013 114 259 A1 beschriebenen HybridSchaltanordnung zu einer Verschweißung der sog. Löschkontakte, kann es beim nachfolgenden Ausschaltvorgang nicht mehr zu einer Kommutierung auf den Leistungshalbleiter kommen, welche durch das mechanische Öffnen der Löschkontakte ermöglicht wird. Durch Ausbleiben der Kommutierung des Laststroms auf den IGBT, verliert der Hybridschalter seine Grundfunktion, durch kurzzeitiges Führen des Laststroms durch den Halbleiter diesen dort zu Null zu führen. Beim Öffnen der für die galvanische Trennung des Hybridschalters zuständigen zweiten mechanischen Kontaktanordnung kann es dann zur Ausbildung eines dauerhaften Lichtbogens und damit zur Zerstörung des Schaltgeräts kommen.

In der deutschen Offenlegungsschrift DE 10 2016 106 414 A1 ist eine Hybridschaltanordnung beschrieben, mit der sich über eine gezielte steuerungstechnische Modifikation eine Kontaktverschweißung beim Einschalten hoher Ströme verhindern lässt, um dadurch eine erhöhte Funktionssicherheit sowie eine möglichst hohe elektrische Lebensdauer zu erzielen. Das Funktionsprinzip dieser Anordnung besteht darin, dass sich der Leistungshalbleiter bereits vor der ersten mechanischen Kontaktgabe im durchgeschalteten Zustand befindet, so dass er während der daran anschließenden Phase des mechanischen Rückprellens der Schaltkontakte den Laststrom immer dann führt, wenn die Schaltkontakte kurzzeitig geöffnet sind. Mit Beendigung der Prellphase erfolgt dann die Stromführung dauerhaft über die geschlossenen Kontakte und der IGBT wird in den Sperrzustand geschaltet.

Auf diese Weise kann vermieden werden, dass es während der Phase des Kontaktprellens zur Ausbildung von Lichtbögen kommt, was im Ergebnis zu einer Verschweißung der Schaltkontakte und damit zu einem möglichen Versagen des Schaltgeräts führen kann.

Das US-Patent US 4,420,784 offenbart eine Hybridschaltanordnung, bei der die Spannung und der Stromfluss über einer von zwei in Reihe geschalteten mechanischen Kontaktanordnungen während des Öffnens einer der Kontaktanordnungen gemessen wird.

Wenn der gemessene Strom und die gemessene Spannung ein vorbestimmtes Verhältnis erreichen, wird durch eine Steuerlogik eine Treiberschaltung aktiviert, welche Leistungs-FETs durchzuschalten, die parallel zu der geöffneten mechanischen Kontaktanordnung geschaltet sind.

Weitere Hybridschaltvorrichtungen sind aus der EP 0 179 982 A2, WO 2017/174326 A1 und EP 0 011 958 A1 bekannt.

US 2005/212497 A1 betrifft einen Gleichstrom-Gleichstrom-Wandler und ein Steuerverfahren dafür, und insbesondere einen Gleichstrom-Gleichstrom-Wandler, der ein unnötiges Schalten minimiert, wenn eine leichte elektrische Last angeschlossen ist, und der einen Wirkungsgrad des Gleichstrom-Gleichstrom-Wandlers und ein Steuerverfahren dafür verbessert.

US 4 420 784 A offenbart einen hybriden Gleichstrom-Leistungsregler vom Typ Relais / Leistungsschalter, der eine hybride Anordnung von Hartkontakten und Leistungs-FETs in zusammenwirkender funktioneller Kombination als Lichtbogenlöschmittel für 270-Volt-Gleichstromsysteme in Umgebungen mit niedrigem atmosphärischem Druck, wie z.B. in 80.000 Fuß Höhe in Flugzeuganwendungen, verwendet. Die Leistungs-FETs werden sowohl beim Öffnen als auch beim Schließen des Stromkreises gesteuert, um einen geschlossenen Kontaktbetrieb in normalen Lastunterbrechungssituationen zu ermöglichen. Strom- und Spannungsmesskreise und Abtastkreise bestimmen, wann die Leistungs-FETs eingeschaltet werden, nachdem der Kontaktlichtbogen die erforderlichen Werte geliefert hat. Trennkontakte im Stromkreis werden durch Verzögerungseinrichtungen so gesteuert, dass sie im Verhältnis zu den Leistungskontakten zuletzt schließen und zuerst öffnen.

Nachfolgend werden Vorrichtungen und Geräte beschrieben, bei denen die Gefahr des Ausbildens ungewollter Schaltlichtbögen reduziert ist und dadurch eine erhöhte Funktionssicherheit sowie eine möglichst hohe elektrische Lebensdauer erzielt werden kann.

Gemäß einem ersten Aspekt wird eine Schaltvorrichtung zum Führen und Trennen von elektrischen Strömen offenbart, mit einer ersten mechanischen Kontaktanordnung, einer zweiten mechanischen Kontaktanordnung, die in Reihe zur ersten mechanischen Kontaktanordnung geschaltet ist, einem Halbleiterschalter, der parallel zur ersten mechanischen Kontaktanordnung geschaltet ist, und einer Schaltelektronik, die zum An- und Abschalten des Halbleiterschalters ausgebildet ist, wobei die Schaltvorrichtung derart ausgebildet ist, dass bei einem Schaltvorgang die beiden mechanischen Kontaktanordnungen zeitlich zueinander verzögert geschlossen werden, und wobei eine Steuerschaltung vorgesehen ist, die ausgebildet ist, eine Spannung über der ersten mechanischen Kontaktanordnung zu ermitteln und abhängig von der ermittelten Spannung ein Ansteuersignal für die Schaltelektronik zu erzeugen, das den Halbleiterschalter anschaltet. Zur Steuerung des Halbleiterschalters werden hierbei die Spannungsverhältnisse über der Reihenschaltung von zwei mechanischen Kontaktanordnungen genutzt, die zeitlich zueinander verzögert geschlossen werden. Bei dieser Schaltvorrichtung ist also eine elektronische Einschaltunterstützung implementiert, welche beim zeitlich verzögerten Schließen der mechanischen Kontaktanordnungen eingesetzt wird und hilft, insbesondere aufgrund von Einschaltprellen einer mechanischen Kontaktanordnung entstehende Lichtbögen zu reduzieren oder gar zu vermeiden. Durch die Überwachung des Spannungszustands an der ersten mechanischen Kontaktanordnung kann eine zeitlich besser an diese angepasste Ansteuerung des Halbleiterschalters implementiert werden. Insbesondere können dadurch Toleranzen, beispielsweise verursacht durch eine Erwärmung einer Spule im Antrieb, Toleranzen von Hüben und/oder Reibung in der Schaltmechanik, Toleranzen aufgrund der Gebrauchslage, berücksichtigt werden, im Gegensatz zu einer fest vorgegebenen Einschaltzeit des Halbleiterschalters, die so bemessen sein muss, dass eine ausreichend große Voreilung beim Einschalten des Halbleiterschalters aufgrund aller möglicherweise auftretenden Toleranzen vorhanden ist.

Insbesondere kann die Steuerschaltung ein Absinken der über der ersten mechanischen Kontaktanordnung anliegenden Spannung ermitteln. Das Absinken der Spannung triggert damit das Erzeugen des Ansteuersignals für die Schaltelektronik. Als Absinken der über der ersten mechanischen Kontaktanordnung anliegenden Spannung kann beispielsweise eine negative Spannungsflanke ermittelt werden, insbesondere ein Absinken der Spannung innerhalb einer vorgegebenen Zeitdauer, beispielsweise ein Absinken von mehr als 50% einer vorgegebenen Spannung innerhalb weniger Millisekunden. Die negative Spannungsflanke kann dynamisch mittels Kondensator erfasst werden.

Die Steuerschaltung kann weiterhin ausgebildet sein, das Ansteuersignal für die Schaltelektronik zu erzeugen, wenn die ermittelte Spannung einen vorgegebenen Schwellwert unterschreitet. Der vorgegebene Schwellwert kann beispielsweise abhängig von den Spannungsverhältnissen über der Reihenschaltung der mechanischen Kontaktanordnungen so gewählt sein, dass er etwas geringer ist als die Spannung bei geschlossener zweiter Kontaktanordnung, so dass beim Schließen der ersten Kontaktanordnung die Spannung unter den vorgegebenen Schwellwert sinkt und somit die Steuerschaltung das Ansteuersignal erzeugen kann.

Die Steuerschaltung kann insbesondere ausgebildet sein, das Ansteuersignal für die Schaltelektronik derart zu erzeugen, dass der Halbleiterschalter nach einer vorgegebenen Zeitdauer angeschaltet wird. Hierdurch kann die Strombelastung des Halbleiterschalters reduziert werden.

Die vorgegebene Zeitdauer kann abhängig vom mechanischen Einschaltverhalten der ersten mechanischen Kontaktanordnung und/oder von der Strombelastbarkeit des Halbleiterschalters gewählt sein. Beispielsweise kann sie so gewählt sein, dass der Halbleiterschalter erst kurz nach oder nahezu zeitgleich mit dem ersten Kontaktierungsvorgang der ersten mechanischen Kontaktanordnung angeschaltet wird und somit die Strombelastung des Halbleiterschalters zeitlich so kurz wie möglich ist.

Die Steuerschaltung weist zudem einen Schalter und einen diesem vorgeschalteten Tiefpass auf, wobei der Schalter das Ansteuersignal für die Schaltelektronik erzeugt. Durch den Tiefpass kann eine Verzögerung der Erzeugung des Ansteuersignals und damit des Anschaltens des Halbleiterschalters definiert werden, insbesondere durch die Zeitkonstante des Tiefpasses.

Die Steuerschaltung kann eine zum Kondensator des Tiefpasses parallel geschaltete Zenerdiode zur Spannungsbegrenzung aufweisen.

Die Steuerschaltung kann weiterhin einen zum Kondensator des Tiefpasses parallel geschalteten Widerstand aufweisen, der mit dem Widerstand des Tiefpasses einen Spannungsteiler zum Erzeugen einer zum Ansteuern des Schalters geeigneten Eingangsspannung bildet.

Der Schalter kann ein normal-sperrender Feldeffekttransistor sein, dessen Laststrecke in Reihe mit einem Widerstand parallel zur Schaltelektronik zwischen ein Versorgungsspannungs- und ein Bezugspotential geschaltet ist, wobei der Schaltelektronik eingangsseitig zur Ansteuerung ein Spannungspotential an dem mit dem Versorgungsspannungspotential verbundenen Anschluss des Widerstands zugeführt wird. Wenn die Spannung am Steueranschluss des Feldeffekttransistors absinkt, so dass dieser zu sperren beginnt, steigt das Spannungspotential an dem mit dem Versorgungsspanungspotential verbundenen Anschluss des Widerstands, so dass die Schaltelektronik den Halbleiterschalter anschalten kann.

Gemäß einem zweiten Aspekt wird ein Schaltgerät offenbart, mit einer Schaltvorrichtung gemäß dem ersten Aspekt und wie hierin offenbart und einem Schaltantrieb zum Bewegen von Kontakten der ersten und zweiten mechanischen Kontaktanordnung.

Weitere Merkmale ergeben sich aus der nachfolgenden Beschreibung in Verbindung mit den in den Zeichnungen dargestellten Ausführungsbeispielen.

Die Zeichnungen zeigen in
Fig. 1 ein Blockschaltbild eines Ausführungsbeispiels einer Schaltvorrichtung mit einer Doppelkontaktanordnung;
Fig. 2 das Schaltbild der in der Schaltvorrichtung von Fig. 1 eingesetzten Steuerschaltung;
Fig. 3 ein Diagramm mit den Verläufen wichtiger Signale eines Ausführungsbeispiels einer Schaltvorrichtung mit einer Doppelkontaktanordnung; und
Fig. 4 ein Diagramm mit den Verläufen wichtiger Signale eines Ausführungsbeispiels einer Schaltvorrichtung mit einer Doppelkontaktanordnung mit Steuerschaltung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht einschränkend zu verstehen.

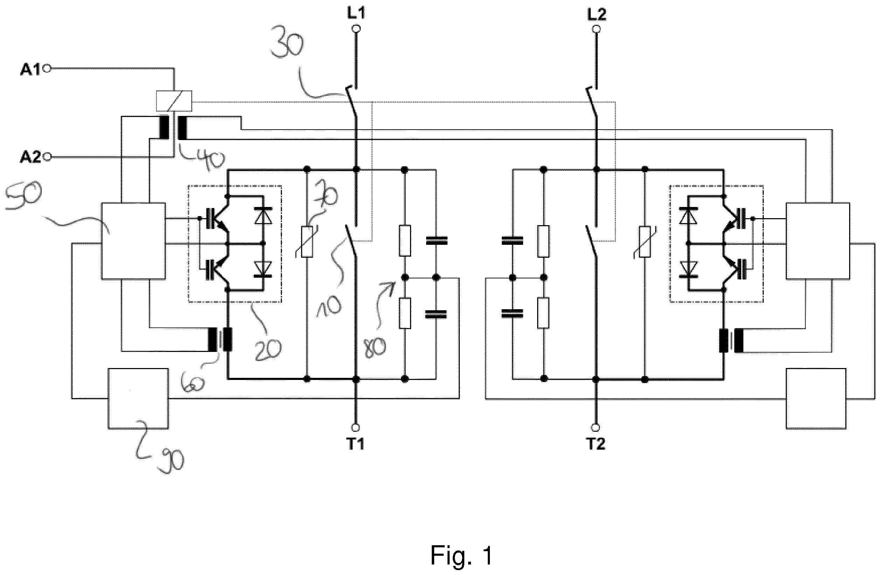

Fig. 1 zeigt das Blockschaltbild einer Schaltvorrichtung für ein 2-poliges, polaritätsunabhängiges Schaltgerät. Die Anschlüsse des Schaltgeräts für die beiden Pole sind jeweils mit L1, T1 und L2, T2 bezeichnet. Diese Schaltvorrichtung entspricht schaltungstechnisch weitgehend der in der deutschen Offenlegungsschrift DE 10 2013 114 259 A1 beschriebenen und darin in Fig. 1 gezeigten Vorrichtung. Von dieser bekannten Vorrichtung unterscheidet sich die nachfolgend beschriebene Vorrichtung in der Steuerschaltung 90, die für eine spezielle Ansteuerung des Halbleiterschalters 20 ausgebildet ist, wie in der nachfolgenden Beschreibung im Detail erläutert wird.

Für jeden Pol weist die in Fig. 1 gezeigte Schaltvorrichtung eine Parallelschaltung einer ersten mechanischen (Lösch-) Kontaktanordnung 10 mit einem Halbleiterschalter 20 auf Basis einer antiseriellen IGBT-Anordnung (Leistungshalbleiter) auf, welche mit einer zweiten mechanischen (Trenn-) Kontaktanordnung 30 zur Sicherstellung der galvanischen Trennung in Serie geschaltet ist (Doppelkontaktanordnung). Die mechanischen Kontaktanordnungen 10 und 30 können als Brückenschaltanordnung eines Luftschaltgeräts bzw. einer Luftschaltgeräteanordnung oder als Doppelanordnung einer Vakuumschaltröhre, wie beispielsweise die in der deutschen Offenlegungsschrift DE 10 2016 108 246 A1 beschriebene Schaltröhre, ausgebildet sein.

Der Halbleiterschalter 20 wird von der Schaltelektronik 50 an- oder abgeschaltet, d.h. durchgesteuert oder gesperrt. Die Schaltelektronik 50 kann von einer in der (Magnetantriebs-) Spule des Schalt- bzw. Magnetantriebs des Schaltgeräts gespeicherten Energie versorgt werden. Hierzu ist eine galvanisch vom Stromkreis des Schaltantriebs getrennte Hilfsspule 40 vorgesehen, welche beim Abschalten des Schaltantriebs eine Spannung zum Versorgen der Schaltelektronik 50 erzeugen kann. Die Hilfsspule 40 kann beispielsweise um die Antriebsspule gewickelt sein.

Zusätzlich oder auch alternativ kann die Schaltelektronik 50 durch eine (nicht dargestellte) externe elektrische Energiequelle versorgt werden, beispielsweise von einer zentralen Energiequelle für die elektrischen Einheiten eines Schaltschranks oder über ein Bussystem, an das mehrere Schaltvorrichtungen gekoppelt sind, und dergleichen.

Im eingeschalteten Fall, d.h. wenn der Schaltantrieb die Magnetantriebs-Spule mit einer Spannung und einem Strom versorgt und die Kontakte der ersten und zweiten mechanischen

Kontaktanordnungen 10 und 30 geschlossen sind, ist der Halbleiterschalter 20 gesperrt, insbesondere da in diesem Zustand von der Hilfsspule 40 keine Spannung zum Versorgen der Schaltelektronik 50 erzeugt wird und die Schaltelektronik 50 daher spannungslos ist und die IGBTs des Halbleiterschalters 20 nicht ansteuern kann.

Im Moment des Einschaltens der Spannungs- und Stromversorgung der Magnetantriebs-Spule des Schaltantriebs zum Schließen der Kontakte der ersten und zweiten mechanischen Kontaktanordnungen 10 und 30 wird in der Magnetantriebs-Spule Energie gespeichert. Durch den Spulenstrom wird in der elektromagnetisch mit der Magnetantriebs-Spule gekoppelten Hilfsspule 40 eine Spannung induziert, welche die Schaltelektronik 50 versorgt.

Die in der Hilfsspule 40 induzierte Spannung reicht aus, um zum einen die Schaltelektronik 50 selbst zu versorgen, zum anderen um die zum Ansteuern der IGBTs erforderliche Spannung aufzubauen. Die Hilfsspule 40 bietet den Vorteil, dass die Ansteuerung des Halbleiterschalters bereits vor Schließen der Kontakte der ersten und zweiten mechanischen Kontaktanordnungen 10 bzw. 30 aufgrund der mechanischen Trägheit erfolgen kann.

Im Moment des Einschaltens der Spannungs- und Stromversorgung der Magnetantriebs-Spule des Schaltantriebs zum Schließen der Kontakte der ersten und zweiten mechanischen Kontaktanordnungen 10 und 30 kann auch eine externe Versorgung aktiviert werden, um die Schaltelektronik 50 zu aktivieren.

Der oben bereits erwähnten Steuerschaltung 90 wird eingangsseitig ein Spannungspotential von einem Knotenpunkt eines parallel zur ersten mechanischen Kontaktanordnung 10 geschalteten Spannungsteilers 80 zugeführt. Anhand dieses Spannungspotentials ermittelt die Steuerschaltung 90 die Spannung über der ersten mechanischen Kontaktanordnung 10 und erzeugt davon abhängig ein Ansteuersignal für die Schaltelektronik 50, damit diese den Halbleiterschalter 20 anschaltet, wie nachfolgend im Detail beschrieben ist.

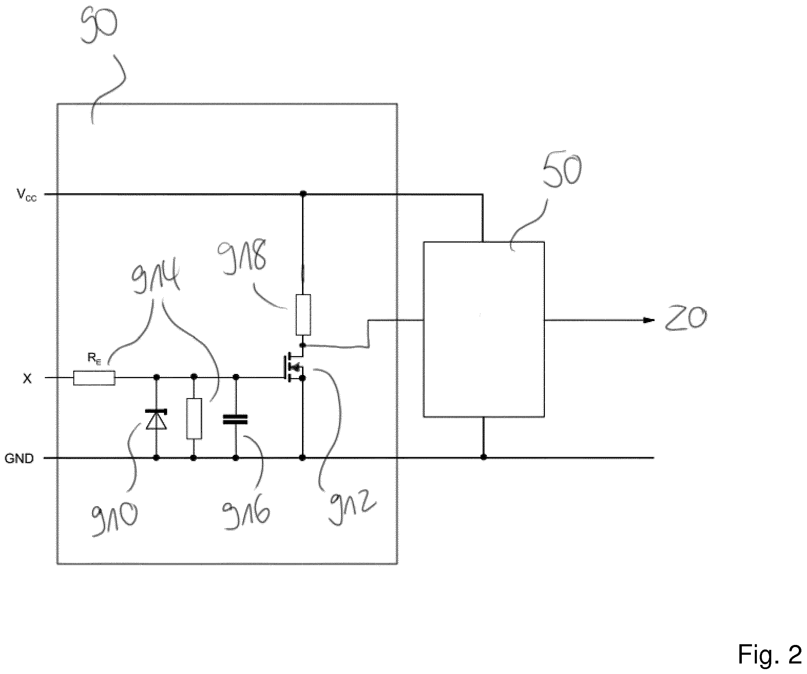

Fig. 2 zeigt die Steuerschaltung 90 im Detail: das eingangsseitige vom Knotenpunkt des Spannungsteilers 80 zugeführte und am Knotenpunkt des Spannungsteilers 80 anliegende Spannungspotential X entspricht der aktuellen Spannung über der mechanischen Kontaktanordnung. Dieses Spannungspotential X wird durch eine zwischen dem Eingang der Steuerschaltung 90 und einem Bezugspotential GND geschaltete Zenerdiode 910 begrenzt.

Das Bezugspotential GND (Masse-Bezugspunkt) entspricht einem Spannungspotential im Halbleiterschalter 20, nämlich dem am Knotenpunkt von zwei zusammengeführten Emitteranschlüssen von IGBTs des Halbleiterschalters 20 vorherrschenden Spannungspotentials. Ein Schalter 912, beispielsweise ein Feldeffekttransistor vom Anreicherungstyp, wird von dem über einen Spannungsteiler 914 geteilte Spannungspotential X angesteuert. Ein zwischen den Steueranschluss des Schalters 912, beispielsweise das Gate eines Feldeffekttransistors und das Bezugspotential GND geschalteter Kondensator 916 mit der Kapazität C dient als Ladungsspeicher und zusammen mit dem Widerstand R_{E} des Spannungsteilers 914 als Verzögerungsglied, durch welches das Schalten der Schalters 912 durch die Zeitkonstante t = R_{E} * C verzögert wird. Die Steuerstrecke des Schalters 912 ist in Reihe mit einem (Pull-Up-) Widerstand 918 zur Signalanpassung an die Schaltelektronik 50 zwischen ein Versorgungsspannungspotential Vcc und das Bezugspotential GND geschaltet.

Nachfolgend wird nun das Einschaltverhalten einer Doppelkontaktanordnung mit verzögerten Schließvorgängen der Kontaktanordnungen und einer Hybridschaltanordnung mit Einschaltunterstützung wie der in Fig. 1 gezeigten, die dadurch zum häufigen Schalten hoher Gleichströme geeignet ist, beschrieben.

Der Einschaltvorgang wird bei der in Fig. 1 gezeigten Anordnung eingeleitet mit der Bestromung einer Antriebsspule eines elektromagnetischen Antriebs für die Betätigung der mechanischen Kontaktanordnungen der Schaltvorrichtung. Gleichzeitig wird die IGBT-Ansteuerelektronik bzw. Schaltelektronik 50 mit Energie versorgt. Nach Abschluss dieses Initialisierungsvorgangs wird der IGBT bzw. Halbleiterschalter 20 bis zum Zeitpunkt der ersten mechanischen Kontaktgabe, welche bei Schaltgeräten für hohe Ströme beispielsweise im Bereich von rd. 10 Millisekunden liegen kann, durch die Einschaltunterstützung gesperrt. Hierdurch wird sichergestellt, dass der Laststrom bei der mechanischen Kontaktgabe des ersten Kontaktpaares der mechanischen Kontaktanordnung 30 noch nicht durch den IGBT 20 geführt wird. Das Schließen der mechanischen Kontaktanordnungen 10, 30 erfolgt bei der in Fig. 1 gezeigten Hybridanordnung zuerst bei der Trenn-Kontaktanordnung 30, welche nach einem Ausschaltvorgang die galvanische Trennung des Hybridschalters sicherstellt. Erst nach einer zeitlichen Verzögerung von typischerweise einigen Millisekunden wird die LöschKontaktanordnung 10 geschlossen.

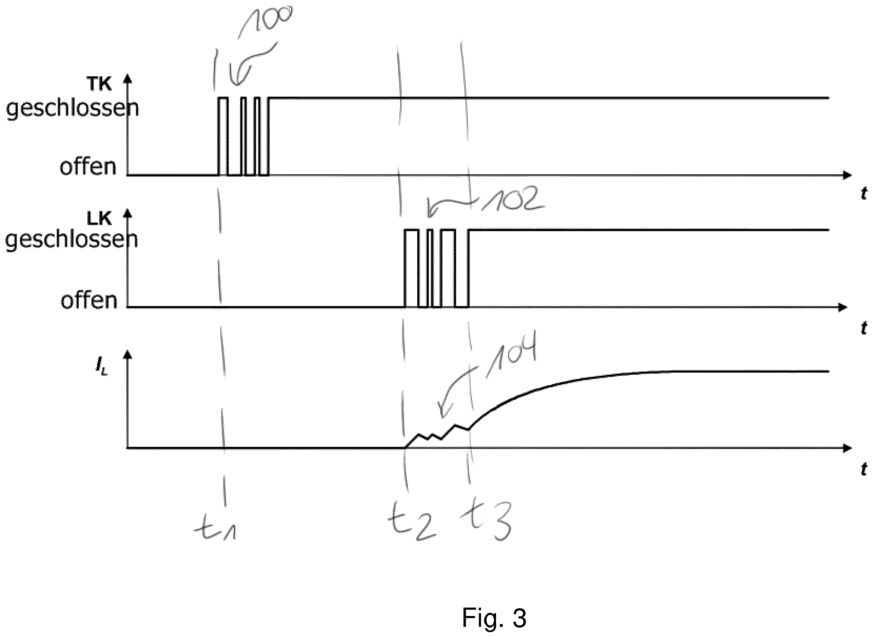

Fig. 3 zeigt den Zustand der (Trenn-) Kontaktanordnung 30 (Verlauf TK) und der (Lösch-) Kontaktanordnung 10 (Verlauf LK) und des Laststroms I_{L} durch den geschalteten Pol bei einer Doppelkontaktanordnung umfassend eine Reihenschaltung der ersten und zweiten mechanischen Kontaktanordnung 10, 30. Zunächst wird zum Zeitpunkt t₁ die mechanische Kontaktanordnung 30 geschlossen, während die mechanische Kontaktanordnung 10 noch geöffnet ist. Daher fließt noch kein Laststrom über den geschalteten Pol. Beim Schließen der Kontaktanordnung 30 tritt in der Regel Kontaktprellen 100 auf, was zu kurzzeitigen Öffnungs- und Schließvorgängen der Kontaktanordnung 30 führt, aufgrund der geöffneten Kontaktanordnung 10 jedoch in der Regel zu keiner Ausbildung von Lichtbögen führt. Verzögert wird dann zum Zeitpunkt t₂ die Kontaktanordnung 10 geschlossen. Bei diesem Schließvorgang tritt ebenfalls in der Regel Kontaktprellen 102 auf, was wiederum zu kurzzeitigen Öffnungs- und Schließvorgängen der Kontaktanordnung 10 führt. Da in diesem Fall bereits die Kontaktanordnung 30 geschlossen ist, beginnt mit dem Schließvorgang der Kontaktanordnung 10 ein Laststrom I_{L} zu fließen. Durch das Kontaktprellen 102 und die damit verbundenen kurzzeitigen Unterbrechungen der Laststromstrecke über den geschalteten Pol kann es zu Einbrüchen 104 im Stromfluss des Laststroms I_{L} kommen, wie im Verlauf des Laststroms im Diagramm während des Kontaktprellens 102 zu erkennen ist. Erst nach Abklingen des Kontaktprellens 102 zum Zeitpunkt t₃ und damit vollständigem Schließen der beiden Kontaktanordnungen 10 und 30 stabilisiert sich der Stromfluss des Laststroms I_{L} über den geschalteten Pol. Während des Kontaktprellens 102 können sich Lichtbögen zwischen den Kontakten der Kontaktanordnung 10 ausbilden, welche zu Beeinträchtigungen der Kontaktfähigkeit oder gar zu einem Verschweißen der Kontakte der Kontaktanordnung 10 führen können.

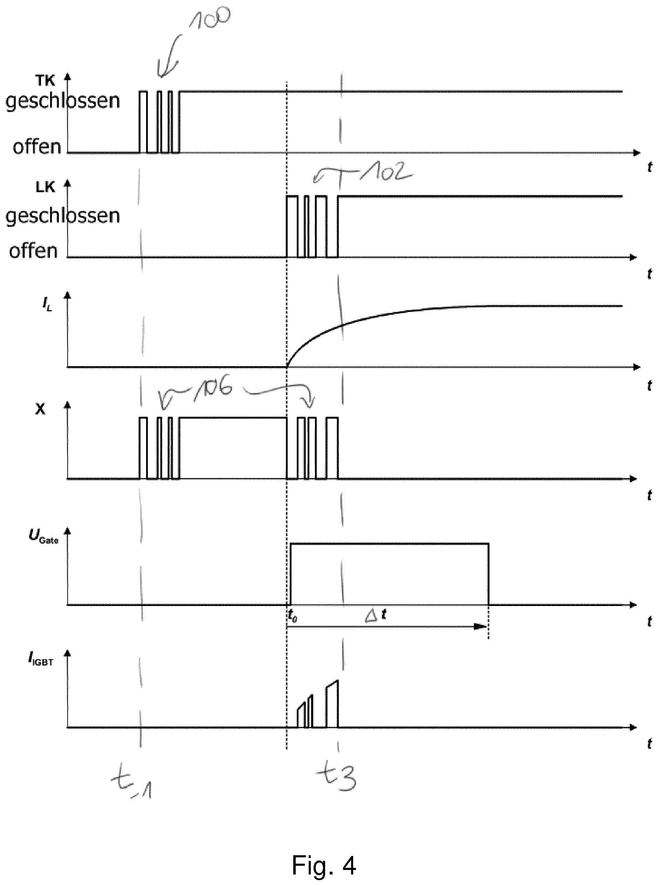

Fig. 4 zeigt den Zustand der (Trenn-) Kontaktanordnung 30 (Verlauf TK) und der (Lösch-) Kontaktanordnung 10 (Verlauf LK) und des Laststroms I_{L} durch den geschalteten Pol bei der in Fig. 1 gezeigten Hybridschaltanordnung mit Einschaltunterstützung, d.h. unter Einsatz der Steuerschaltung 90. Zusätzlich sind in Fig. 4 die Verläufe des Spannungspotentials X, der Spannung am Gate des Feldeffekttransistors 912 und der Strom durch den IGBT bzw. Halbleiterschalter 20 dargestellt. Zunächst wird zum Zeitpunkt t-i wieder die mechanische Kontaktanordnung 30 geschlossen, während die mechanische Kontaktanordnung 10 noch geöffnet ist. Daher fließt noch kein Laststrom über den geschalteten Pol. Das beim Schließen der Kontaktanordnung 30 in der Regel auftretende Kontaktprellen 100 bewirkt entsprechende Schwankungen oder gar Einbrüche 106 des Spannungspotentials X, die nach Beenden des Kontaktprellens aufhören, so dass sich das Spannungspotential X wieder auf seinen entsprechenden Wert bei geöffneter Schaltstrecke bzw. offenem Pol einstellen kann.

Verzögert wird dann zum Zeitpunkt to die Kontaktanordnung 10 geschlossen. Das bei diesem Schließvorgang in der Regel auftretende Kontaktprellen 102 bewirkt wiederum entsprechende Schwankungen oder gar Einbrüche 106 des Spanungspotentials X. Ab dem Zeitpunkt to beginnt der Laststrom I_{L} zu fließen.

Im Unterschied zu dem in Fig. 3 gezeigten Verlauf des Laststroms I_{L} wird jedoch zum Zeitpunkt to während des Schließvorgangs der Kontaktanordnung 10 der parallel zu dieser geschaltete Halbleiterschalter 20 geschlossen, so dass der Stromfluss des Laststromes auf den Halbleiterschalter 20 kommutieren kann. Der Halbleiterschalter 30 bleibt hierbei solange geschlossen, bis das Kontaktprellen 102 abgeklungen und die Kontaktanordnung 10 stabil geschlossen ist. Daher kommt es in der Regel zu keinen oder zumindest nur sehr geringen Einbrüchen im Stromfluss des Laststroms I_{L} während des Schließen der Kontaktanordnung 10, wie sich aus dem Verlauf des Laststroms I_{L} ergibt.

Das Steuern des IGBTs bzw. Halbleiterschalters 20 wird bei der in Fig. 1 gezeigten Schaltungsanordnung über die Steuerschaltung 90 wie folgt durchgeführt: durch den Schließvorgang der (Trenn-) Kontaktanordnung 30 zum Zeitpunkt t-i wird bewirkt, dass die Lastspannung, welche zuvor über der gesamten Schaltstrecke umfassend die beiden Kontaktanordnungen 10, 30 anlag, nun über der noch geöffneten (Lösch-) Kontaktanordnung 10 liegt.

Am IGBT bzw. Halbleiterschalter 20, der sich bis zu diesem Zeitpunkt im Sperrzustand befand, wird mit dem Schließen der (Trenn-) Kontaktanordnung 30 der Sperrzustand noch solange aufrechterhalten, bis es zur ersten mechanischen Kontaktgabe der (Lösch-) Kontaktanordnung 10 kommt. Mit dem Schließen der (Lösch-) Kontaktanordnung 10 verschwindet auch die über diesem Kontaktpaar liegende Lastspannung, d.h. das Spannungspotential X sinkt etwa auf null, was mit einem Signal für die IGBT-Ansteuerung bzw. Schaltelektronik 50 in der Weise verbunden ist, dass der Halbleiterschalter 20 beispielweise etwa 100 Mikrosekunden verzögert nach Kontaktgabe in den leitenden Zustand geschaltet wird, wie durch die Ansteuerspannung U_{Gate} der IGBTs des Halbleiterschalters 20 in Fig. 4 dargestellt ist. Die Verzögerung wird hierbei durch die Steuerschaltung 90 und durch den in dieser enthaltenen Tiefpass bewirkt. Die Steuerschaltung 90 stellt zudem sicher, dass die Schaltelektronik 50 eingangsseitig mit einem passenden Signal angesteuert wird.

Mit dem Wiederöffnen der (Lösch-) Kontaktanordnung 10 infolge des Prellvorgangs kann dann der Laststrom sofort auf den durchgeschalteten IGBT des Halbleiterschalters 20 kommutieren, wo er solange geführt wird (siehe Strom I_{IGBT} in Fig. 4), bis es zur Rekontaktierung der Löschkontakte kommt und der Strom über die mechanischen Kontakte fließen kann. Bei einem erneuten Rückprellen wird der Laststrom abermals vom IGBT des Halbleiterschalters 20 übernommen. Dieser Kommutierungsvorgang setzt sich solange fort, bis es zur dauerhaften Kontaktierung gekommen ist. Nach einem sicheren zeitlichen Abstand Δt ab der ersten Kontaktgabe wird der IGBT des Halbleiterschalters 20 dann wieder in den Sperrzustand geschaltet.

Im Hinblick auf eine möglichst hohe elektrische Lebensdauer der IGBTs des Halbleiterschalters 20 sowie auf deren vertretbar große Dimensionierung ist es zweckmäßig, den Stromfluss durch den Halbleiterschalter 20 zeitlich in der Weise zu begrenzen, dass der Strom dort nur so lange fließt, bis die mechanische Schaltstrecke durch Abschluss des mechanischen Prellvorgangs völlig zur Ruhe gekommen ist. Für die Minimierung der Stromflusszeit durch den Halbleiterschalter 20 ist die genaue Kenntnis des Zeitpunkts der ersten Kommutierung wichtig, da bei jedem Schaltgerät die effektiven Zeiten für den mechanischen Anschaltvorgang aus verschiedenen Gründen schwanken.

Der Zeitpunkt der Kommutierung auf den bereits durchgesteuerten IGBT des Halbleiterschalters 20 kann durch einen dort befindlichen Stromwandler 60 (Fig. 1) erfasst werden. Der Stromwandler 60 erzeugt ein Signal, sobald durch die IGBTs des Halbleiterschalters 20 ein Strom zu fließen beginnt, der Stromfluss also von der ersten mechanischen Kontaktanordnung 10 auf den Halbleiterschalter 20 kommutiert. Das vom Stromwandler 60 erzeugte und die Kommutierung signalisierende Signal wird der Schaltelektronik 50 zugeführt, die davon abhängig den Halbleiterschalter 20 wie im Folgenden beschrieben ansteuern kann.

Unmittelbar nach erfolgter Kommutierung kann die Schaltelektronik 50 den Halbleiterschalter 20 in der Weise ansteuern, dass die IGBTs des Halbleiterschalters 20 nach kurzer, über die Schaltelektronik 50 definierter bzw. vorgegebener Stromflusszeit bzw. Stromleitzeit (beispielsweise die Zeitdauer Δt) wieder sperrend werden, so dass der kommutierte Laststrom im Halbleiterschalter 20 innerhalb der definierten Zeitdauer Δt zu null geführt wird und die Strombelastung der IGBTs des Halbleiterschalters 20 begrenzt ist. Die Stromflusszeit ist idealerweise über die Schaltelektronik 50 so bemessen, dass die Schaltstrecke mit der ersten und zweiten mechanischen Kontaktanordnung 10 bzw. 30 vollständig geschlossen ist, d.h. die Schaltkontakte dauerhaft kontaktiert sind und eventuelle Schaltprellvorgänge nicht mehr auftreten.

Es kann zudem das Signal vom Stromwandler 60 von der Schaltelektronik 50 ausgewertet werden, und sobald signalisiert wird, dass der Stromfluss über den Halbleiterschalter 20 wieder abnimmt oder etwa Null ist wie zum Zeitpunkt t₃, da die Schaltkontakte der beiden mechanischen Kontaktanordnungen 10 und 30 nun dauerhaft kontaktiert sind und kein Prellen der Schaltkontakte mehr stattfindet, kann die Schaltelektronik 50 die IGBTs des Halbleiterschalters 20 wieder sperren und den Stromfluss über den Halbleiterschalter 20 unterbrechen, was bereits vor Ablauf der Zeitdauer Δt₁ stattfinden kann.

Durch die Ausstattung des Halbleiterschalters 20 mit einem antiseriellen IGBT ist eine solche Schaltanordnung sowohl für DC-Ströme mit beliebiger Stromflussrichtung als auf für Wechselspannungen unterschiedlicher Frequenz einsetzbar, wobei der Schaltzeitpunkt aufgrund der unabhängigen Versorgung des Ansteuermoduls nicht phasenwinkelabhängig ist.

Während des Abschaltvorgangs im Halbleiterschalter 20 kommt es bei hohen Strömen zu hohen dl/dt-Werten, wodurch Spannungsspitzen deutlich oberhalb 1 kV entstehen können. Zum Schutz vor solchen Spannungsspitzen ist es zweckmäßig, dem Halbleiterschalter 20 ein Schutzorgan, z.B. in Form eines Varistors 70 (Fig. 1) vorzuschalten oder parallel zu schalten.

Zusammenfassend wird also der Spannungszustand der Löschkontaktanordnung überwacht, und davon abhängig erfolgt die zeitliche Steuerung des Halbleiterschalters. Die Überwachung des Spannungszustands ist hierbei keine Spannungsmessung im herkömmlichen Sinn, sondern im Prinzip eine Art Ereignisdetektion, d.h. wenn die Spannung an der Löschkontaktanordnung abfällt, wird die zeitliche Steuerung des Halbleiterschalters getriggert. Mit dem Schließen der Trennkontaktanordnung und dem daraus resultierenden Spannungsanstieg an der Löschkontaktanordnung wird die Einschaltunterstützung aktiviert, jedoch ohne, dass der Halbleiterschalter bereits angesteuert wird. Erst mit dem folgenden Schließen des Löschkontaktes und der daraus folgenden negativen Spannungsflanke wird dann das Zuschalten des Halbleiterschalters getriggert. Das Spannungssignal (Flankensignal) dient hierbei als Zeitgeber für die exakte physikalische Kontaktgabe der Trenn- und der Löschkontaktanordnung. Das hat folgende Vorteile:
- Der Halbleiterschalter wird tatsächlich nur während einer Kontaktabhebung während des Schließvorgangs der Löschkontaktanordnung mit einem Strom beaufschlagt. Dies entspricht der geringsten mit einem gegebenen mechanischen System zur erzielenden Strombelastung.
- Alle mechanischen Toleranzen (Hubtoleranzen, Reibung, etc.) oder durch Umwelteinflüsse hervorgerufenen Toleranzen (Wärme, Einbaulage, etc.) können nahezu vollständig eliminiert werden.
- Eine Überschneidung des Schließens des Halbleiterschalters mit dem Schließen der Trennkontaktanordnung ist auch bei einer kleinen Voreilung der Trennkontaktanordnung ausgeschlossen. D.h. der Trennkontakt schaltet ebenfalls Lichtbogenfrei ein.

Die Spannungserfassung an der Trennkontaktanordnung dient wie oben erläutert hierbei im Wesentlichen als Trigger für einen Zeitmarker zum Aktivieren bzw. Einschalten des Halbleiterschalters und muss daher nicht als lineare Spannungsmessung ausgeführt sein. Vielmehr erfolgt die Erzeugung des "Spannungssignals" durch eine dynamische Erfassung (Flanke) mittels der Kondensatoren im "Messkreis".

Die in der vorliegenden Beschreibung erläuterten Implementierungen eignen sich insbesondere zum Einsatz in Schützen, Leistungsschaltern und Motorschutzschaltern, die insbesondere für einen Betrieb mit Gleichströmen und/oder niederfrequenten Strömen ausgelegt sind. Sie ermöglicht das Schalten von hohen Gleichströmen und niederfrequenten Strömen bei einer vergleichsweise hohen elektrischen Lebensdauer, da lange Lichtbogenbrenndauern ebenso wie eine lange Strombelastung des Halbleiterschalters vermieden werden können. Weiterhin gestatten diese Eigenschaften die Realisierung von vergleichsweise kompakten Schaltgeräten für hohe Ströme.

## Patentansprüche

1. Schaltvorrichtung zum Führen und Trennen von elektrischen Strömen mit
- einer ersten mechanischen Kontaktanordnung (10),
- einer zweiten mechanischen Kontaktanordnung (30), die in Reihe zur ersten mechanischen Kontaktanordnung geschaltet ist,
- einem Halbleiterschalter (20), der parallel zur ersten mechanischen Kontaktanordnung geschaltet ist, und
- einer Schaltelektronik (50), die zum An- und Abschalten des Halbleiterschalters (20) ausgebildet ist,
- wobei die Schaltvorrichtung derart ausgebildet ist, dass bei einem Schaltvorgang die beiden mechanischen Kontaktanordnungen (10, 30) zeitlich zueinander verzögert geschlossen werden,
- einer Steuerschaltung (90), die ausgebildet ist, eine Spannung über der ersten mechanischen Kontaktanordnung (10) zu ermitteln und abhängig von der ermittelten Spannung ein Ansteuersignal für die Schaltelektronik (50) zu erzeugen, das den Halbleiterschalter (20) anschaltet
**dadurch gekennzeichnet, dass**
- die Steuerschaltung (90) einen Schalter und einem diesem vorgeschalteten Tiefpass aufweist, wobei der Schalter das Ansteuersignal für die Schaltelektronik (50) erzeugt.

2. Schaltvorrichtung nach Anspruch 1,
**dadurch gekennzeichnet, dass**
die Steuerschaltung (90) ausgebildet ist, das Ansteuersignal für die Schaltelektronik (50) zu erzeugen, wenn sie ein Absinken der über der ersten mechanischen Kontaktanordnung anliegenden Spannung ermittelt.

3. Schaltvorrichtung nach Anspruch 2,
**dadurch gekennzeichnet, dass**
die Steuerschaltung (90) ausgebildet ist, das Ansteuersignal für die Schaltelektronik (50) zu erzeugen, wenn die ermittelte Spannung einen vorgegebenen Schwellwert unterschreitet.

4. Schaltvorrichtung nach Anspruch 1, 2 oder 3,
**dadurch gekennzeichnet, dass**
die Steuerschaltung (90) ausgebildet ist, das Ansteuersignal für die Schaltelektronik (50) derart zu erzeugen, dass der Halbleiterschalter (20) nach einer vorgegebenen Zeitdauer angeschaltet wird.

5. Schaltvorrichtung nach Anspruch 4,
**dadurch gekennzeichnet, dass**
die vorgegebene Zeitdauer abhängig vom mechanischen Einschaltverhalten der ersten mechanischen Kontaktanordnung (10) und/oder von der Strombelastbarkeit des Halbleiterschalters (20) gewählt ist.

6. Schaltvorrichtung nach einem der vorhergehenden Ansprüche,
**dadurch gekennzeichnet, dass**
die Steuerschaltung (90) eine zum Kondensator des Tiefpasses parallel geschaltete Zenerdiode zur Spannungsbegrenzung aufweist.

7. Schaltvorrichtung nach einem der vorhergehenden Ansprüche,
**dadurch gekennzeichnet, dass**
die Steuerschaltung (90) einen zum Kondensator des Tiefpasses parallel geschalteten Widerstand aufweist, der mit dem Widerstand des Tiefpasses einen Spannungsteiler zum Erzeugen einer zum Ansteuern des Schalters geeigneten Eingangsspannung bildet.

8. Schaltvorrichtung nach einem der vorhergehenden Ansprüche,
**dadurch gekennzeichnet, dass**
der Schalter ein normal-sperrender Feldeffekttransistor ist, dessen Laststrecke in Reihe mit einem Widerstand parallel zur Schaltelektronik (50) zwischen ein Versorgungsspannungs- und ein Bezugspotential geschaltet ist, wobei der Schaltelektronik (50) eingangsseitig zur Ansteuerung ein Spannungspotential an dem mit dem Versorgungsspanungspotential verbundenen Anschluss des Widerstands zugeführt wird.

9. Schaltgerät mit
- einer Schaltvorrichtung nach einem der vorhergehenden Ansprüche und
- einem Schaltantrieb zum Bewegen von Kontakten der ersten und zweiten mechanischen Kontaktanordnung.

## Claims

1. A switching device for conducting and disconnecting electrical currents having
- a first mechanical contact arrangement (10),
- a second mechanical contact arrangement (30) connected in series with the first mechanical contact arrangement,
- a semiconductor switch (20) connected in parallel to the first mechanical contact arrangement, and
- a switching electronic system (50) which is designed for switching the semiconductor switch (20) on and off,
- wherein the switching device is designed such that during a switching operation the two mechanical contact arrangements (10, 30) are closed with a time delay relative to one another,
- a control circuit (90) which is designed to determine a voltage across the first mechanical contact arrangement (10) and, depending on the determined voltage, to generate a control signal for the switching electronic system (50) which switches on the semiconductor switch (20)
**characterized in that**
- the control circuit (90) has a switch and a low-pass filter connected upstream thereof, wherein the switch generates the control signal for the switching electronic system (50).

2. The switching device according to claim 1,
**characterized in that**
the control circuit (90) is designed to generate the control signal for the switching electronic system (50) when it detects a drop in the voltage applied across the first mechanical contact arrangement.

3. The switching device according to claim 2,
**characterized in that**
the control circuit (90) is designed to generate the control signal for the switching electronic system (50) when the determined voltage falls below a predetermined threshold value.

4. The switching device according to claim 1, 2 or 3,
**characterized in that**
the control circuit (90) is designed to generate the control signal for the switching electronic system (50) such that the semiconductor switch (20) is switched on after a predetermined period of time.

5. The switching device according to claim 4,
**characterized in that**
the predetermined time period is selected depending on the mechanical switch-on behavior of the first mechanical contact arrangement (10) and/or on the current carrying capacity of the semiconductor switch (20).

6. The switching device according to one of the preceding claims,
**characterized in that**
the control circuit (90) has a Zener diode connected in parallel to the capacitor of the low-pass filter for voltage limitation.

7. The switching device according to one of the preceding claims,
**characterized in that**
the control circuit (90) has a resistor connected in parallel to the capacitor of the low-pass filter, which resistor forms a voltage divider with the resistor of the low-pass filter for generating an input voltage suitable for controlling the switch.

8. The switching device according to one of the preceding claims,
**characterized in that**
the switch is a normally-off field effect transistor whose load path is connected in series with a resistor parallel to the switching electronic system (50) between a supply voltage and a reference potential, wherein the switching electronic system (50) is supplied with a voltage potential on the input side for control at the terminal of the resistor connected to the supply voltage potential.

9. A switching apparatus having
- a switching device according to one of the preceding claims and
- a switching drive for moving contacts of the first and second mechanical contact arrangements.

## Revendications

1. Dispositif de commutation permettant de conduire et de déconnecter des courants électriques, comportant
- un premier agencement de contact (10) mécanique,
- un second agencement de contact (30) mécanique, lequel est connecté en série au premier agencement de contact mécanique,
- un commutateur à semi-conducteur (20), lequel est connecté en parallèle au premier agencement de contact mécanique, et
- une électronique de commutation (50), laquelle est conçue pour activer et déactiver le commutateur à semi-conducteur (20),
- dans lequel le dispositif de commutation est conçu de telle sorte que lors d'un processus de commutation, les deux agencements de contact (10, 30) mécaniques sont fermés de manière retardée l'un par rapport à l'autre,
- un circuit de commande (90), lequel est conçu pour déterminer une tension au niveau du premier agencement de contact (10) mécanique et, en fonction de la tension déterminée, pour générer un signal de commande pour l'électronique de commutation (50), lequel active le commutateur à semi-conducteur (20)
**caractérisé en ce que**
- le circuit de commande (90) présente un commutateur et un passe-bas connecté en amont, dans lequel le commutateur génère le signal de commande pour l'électronique de commutation (50).

2. Dispositif de commutation selon la revendication 1,
**caractérisé en ce que**
le circuit de commande (90) est conçu pour générer le signal de commande pour l'électronique de commutation (50) lorsqu'il détecte une chute de tension présente aux bornes du premier agencement de contact mécanique.

3. Dispositif de commutation selon la revendication 2,
**caractérisé en ce que**
le circuit de commande (90) est conçu pour générer le signal de commande pour l'électronique de commutation (50) lorsque la tension déterminée est inférieure à une valeur seuil prédéterminée.

4. Dispositif de commutation selon la revendication 1, 2 ou 3,
**caractérisé en ce que**
le circuit de commande (90) est conçu pour générer le signal de commande pour l'électronique de commutation (50) de telle sorte que le commutateur à semi-conducteur (20) est activé après une durée prédéterminée.

5. Dispositif de commutation selon la revendication 4,
**caractérisé en ce que**
la durée prédéterminée est sélectionnée en fonction du comportement mécanique à l'activation du premier agencement de contact (10) mécanique et/ou de la capacité de transport de courant du commutateur à semi-conducteur (20).

6. Dispositif de commutation selon l'une quelconque des revendications précédentes,
**caractérisé en ce que**
le circuit de commande (90) comporte une diode Zener connectée en parallèle au condensateur du passe-bas pour limiter la tension.

7. Dispositif de commutation selon l'une quelconque des revendications précédentes,
**caractérisé en ce que**
le circuit de commande (90) comporte une résistance connectée en parallèle au condensateur du passe-bas, laquelle forme un diviseur de tension avec la résistance du passe-bas pour générer une tension d'entrée appropriée pour la commande du commutateur.

8. Dispositif de commutation selon l'une quelconque des revendications précédentes,
**caractérisé en ce que**
le commutateur est un transistor à effet de champ normalement bloquant, dont le trajet de charge est connecté en série à une résistance en parallèle à l'électronique de commutation (50) entre un potentiel de tension d'alimentation et un potentiel de référence, dans lequel l'électronique de commutation (50), côté entrée pour la commande, est alimentée par un potentiel de tension au niveau de la borne reliée au potentiel de tension d'alimentation de la résistance.

9. Appareil de commutation comportant
- un dispositif de commutation selon l'une quelconque des revendications précédentes et
- un entraînement de commutation pour déplacer les contacts des premier et second agencements de contact mécaniques.
